Europäisches Patentamt

**European Patent Office**

**Office européen des brevets**

(11) Numéro de publication: **0 266 264 B1**

(12) **FASCICULE DE BREVET EUROPEEN**

(45) Date de publication de fascicule du brevet: **16.12.92** (51) Int. Cl.⁵: **H01Q 1/28**, H01Q 9/28, G01R 31/00

(21) Numéro de dépôt: **87402344.3**

(22) Date de dépôt: **20.10.87**

(54) Simulateur d'agression par impulsion électromagnétique.

(30) Priorité: **24.10.86 FR 8614833**

(43) Date de publication de la demande:
**04.05.88 Bulletin 88/18**

(45) Mention de la délivrance du brevet:
**16.12.92 Bulletin 92/51**

(84) Etats contractants désignés:
**CH DE ES GB IT LI**

(56) Documents cités:
**US-A- 2 267 889**
**US-A- 2 593 427**
**US-A- 3 568 201**
**US-A- 3 823 402**

**DIGEST OF TECHNICAL PAPERS OF THE 5TH IEEE PULSED POWER CONFERENCE, Arlington, Virginia, 10-12 juin 1985, éditors P.J. TURCHI et al., pages 135-138; A. BUSHNELL et al.: "A multimeagavolt generator for HEMP simulation"**

(73) Titulaire: **THOMSON-CSF**
**51, Esplanade du Général de Gaulle**
**F-92800 Puteaux(FR)**

(72) Inventeur: **Gallou, André**
**THOMSON-CSF SCPI 19, avenue de Messine**
**F-75008 Paris(FR)**
Inventeur: **Jeannolle, Joel**
**THOMSON-CSF SCPI 19, avenue de Messine**
**F-75008 Paris(FR)**

(74) Mandataire: **Courtellemont, Alain et al**
**THOMSON-CSF SCP B.P. 329**
**F-92402 COURBEVOIE CEDEX(FR)**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

Rank Xerox (UK) Business Services

## Description

La présente invention se rapporte aux simulateurs d'agression par impulsion élecrotromagnétique, destinés à produire, en un instant extrêmement bref, une onde électromagnétique intense. De tels simulateurs servent, par exemple, à tester l'efficacité de moyens mis en oeuvre pour protéger des éléments fragiles de circuits électroniques qui, sans cette protection, seraient, à coup sur, détruits par une onde électromagnétique intense.

Il est connu d'employer des simulateurs comportant une antenne cônique, placée pointe tournée vers le bas, notamment pour rayonner des ondes en polarisation verticale. L'antenne mesure plusieurs dizaines de mètres de haut et constitue, avec la charpente qui lui sert de support, un ensemble relativement imposant, difficile et très long à installer, peu souple d'emploi et coûteux.

La présente invention a pour but d'éviter ou, pour le moins, de réduire ces inconvénients.

Ceci est obtenu grâce à un simulateur conçu pour être transporté par voie aérienne et pour pouvoir être utilisé à des distances du sol plus ou moins grandes.

Selon l'invention un simulateur d'agression par impulsion électromagnétique, comportant une antenne à éléments rayonnants disposés sensiblement pour former un cône à pointe tournée vers le bas, un générateur d'impulsions couplé à l'antenne et un déclencheur pour déclencher un signal de sortie du générateur, est caractérisé en ce qu'il est conçu pour être aéroporté et pour fonctionner alors qu'il est aéroporté et en ce qu'il comporte pour cela un dispositif d'écartemet pour maintenir la forme du cône, au moins lors du fonctionnement du simulateur, et en ce que l'antenne comporte un contrepoids radioélectrique couplé électriquement aux éléments rayonnants par le générateur et disposé verticalement au-dessous de la pointe du cône, du moins lors du fonctionnement du simulateur.

Il est à noter qu'il est connu par le brevet US-A-2 593 427 de réaliser un émetteur radio suspendu à un parachute, avec une antenne filaire pendant sous le parachute et dans lequel les haubans du parachute servent également de contrepoids. Un tel dispositif ne constitue qu'un arrière-plan technologique assez lointain pour l'invention étant en particulier, que l'invention concerne un simulateur d'agression par impulsion électromagnétique et non pas un simple émetteur radio, que le contrepoids est sous les haubans et non pas dans les haubans et que l'antenne est une antenne conique placée dans les baubans et non pas une antenne filaire pendant sous les haubans.

La présente invention sera mieux comprise et d'autres caractéristiques apparaîtront à l'aide de la description ci-après et des figures s'y rapportant qui représentent :

- la figure 1, un schéma d'une première réalisation d'un simulateur selon l'invention,
- la figure 2, un schéma électrique du simulateur de la figure 1,
- la figure 3, un schéma d'une seconde réalisation d'un simulateur selon l'invention.

Sur les différentes figures les éléments correspondants sont désignés par les mêmes repères.

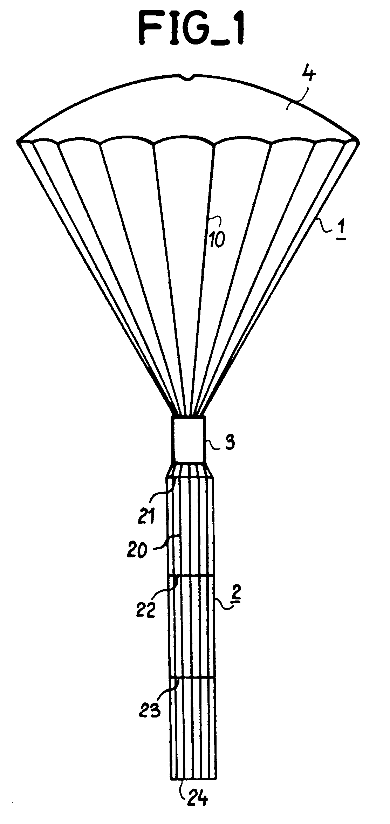

La figure 1 représente un simulateur réalisé de manière à constituer un parachute. Ce simulateur comporte en effet une antenne de type conique avec des éléments filaires rayonnants, tels que 10, qui forment un cône 1 et sont solidaires, à une de leurs extrémités, d'une coupole 4 et, à l'autre de leurs extrémités, d'une nacelle ; la nacelle soutient un contrepoids radioélectrique 2. La coupole 4 est une coupole classique de parachute, formée de fuseaux de tissu cousus ensemble. Dans l'exemple décrit les éléments rayonnants du cône sont, en fait, ligaturés chacun le long d'un câble synthétique et les câbles synthétiques constituent les suspentes du parachute tandis que les éléments rayonnants n'ont qu'un rôle radioélectrique ; ce montage a l'avantage de simplifier l'étude et la réalisation du simulateur en séparant les fonctions mécaniques et radioélectriques mais il est également possible d'utiliser les éléments rayonnants du cône de l'antenne pour constituer les suspentes du parachute.

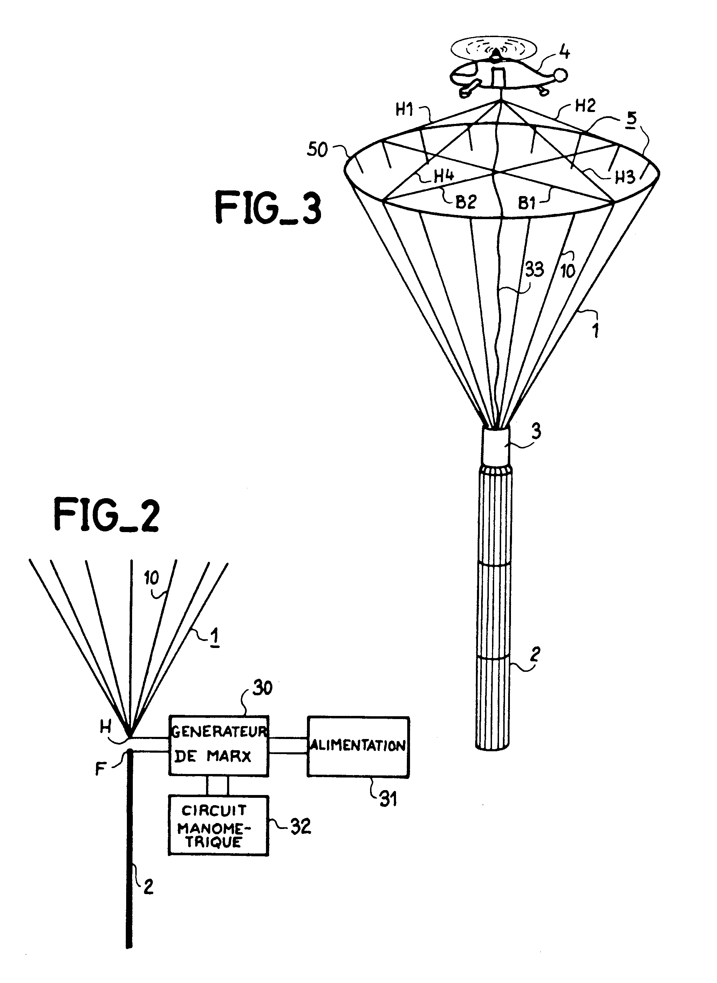

La nacelle 3 comporte, dans une enveloppe cylindrique de protection, un dispositif d'excitation qui sera précisé à l'aide de la figure 2.

Le contrepoids 2 est constitué par un ensemble d'éléments filaires rayonnants, tels que 20, disposés sensiblement selon les génératrices d'un cylindre vertical et maintenus en position par des écarteurs 21 à 24 ; il est à noter que les écarteurs peuv ent aussi bien être réalisés en matériau isolant qu'en matériau conducteur, étant donné que le champ électrique à l'intérieur du contrepoids est nul. Dans cette antenne isolée du sol, puisque destinée à fonctionner lors de sa descente en parachute, le contrepoids 2 remplace la prise de terre d'une antenne de type conique, électriquement reliée à la terre.

La figure 2 est un schéma électrique montrant l'antenne de type conique avec son cône, 1, et son contrepoids, 2, et les circuits du dispositif d'excitation 3 contenu dans la nacelle de la figure 1.

Dans l'exemple de réalisation qui a servi à la description selon les figures 1 et 2 le cône 1 présente un angle au sommet d'environ 60 degrés et est formé de 25 éléments rayonnants d'environ 30 m chacun ; le contrepoids 2 comporte 12 fils conducteurs également d'environ 30 m chacun et constitue un cylindre ; l'antenne ainsi réalisée présente une bonne impédance d'antenne aux alentours de 5 MHz.

Les circuits du dispositif d'excitation sont connectés entre le point chaud de l'antenne, H, que constitue la pointe du cône 1, et le point froid de l'antenne, F, que constitue le haut du contrepoids 2 ; ces circuits du dispositif d'excitation de l'antenne comportent un générateur d'impulsions, 30, du type générateur de Marx, dont les sorties sont reliées aux points H et F de l'antenne, une alimentation 31 pour alimenter le générateur et un circuit manomètrique 32. Il est rappelé qu'un générateur de Marx est constitué par un ensemble de condensateurs associés à des éclateurs de manière à pouvoir être chargés en parallèle et déchargés en série ; dans l'exemple décrit les condensateurs sont des condensateurs produits spécialement par la société française LCC et présentent les caractéristiques suivantes : pavé de forme cylindrique d'environ 20 cm de diamètre et 10 cm de hauteur, tension d'utilisation de 100 kV. L'alimentation 31 comporte un jeu de piles au lithium, montées pour fournir une tension continue de 24 V, et un convertisseur continu-continu permettant de passer de 24 V à 100 kV. Le circuit manomètrique 32 est un circuit de commande de déclenchement du générateur de Marx 30 en fonction de l'altitude grâce aux indications fournies par une capsule manomètrique ; dans l'exemple décrit le circuit 32 permet de choisir entre un et cinq déclenchements du générateur de Marx, par parachutage, et permet de choisir l'altitude à laquelle doit se produire chacun des déclenchements.

La figure 3 représente un simulateur conçu pour être transporté par un hélicoptère, 4, protégé contre les champs électromagnétiques intenses. Le simulateur ayant servi d'exemple pour ce schéma présente le même cône, 1, à éléments rayonnants, 10, et le même contrepoids, 2, que le simulateur selon le schéma de la figure 1 ; ses caractéristiques électriques sont les mêmes, à la différence près que le circuit manomètrique 32 (voir figure 2) de déclenchement du générateur de Marx est remplacé par une commande à distance, placée dans l'hélicoptère de manière à être utilisée au moment choisi par un opérateur voyageant dans l'hélicoptère. Un câble multifilaire 33 assure les liaisons électriques entre l'hélicoptère 4 et la nacelle 3 avec, en particulier, la liaison relative à la commande à distance mentionnée ci-avant et la liaison entre les piles au lithium de l'alimentation du générateur de Marx, transportées dans l'hélicoptère, et le convertisseur continu-continu de cette même alimentation, transporté dans la nacelle.

La différence principale entre le simulateur selon la figure 3 et le simulateur selon la figure 1 réside dans le fait que la coupole de parachute est remplacée par un élément porteur 5, constitué par quatre haubans H1 à H4 (en fait, dans l'exemple décrit, il y a douze haubans mais, pour la clarté du schéma seuls quatre de ces haubans ont été représentés sur la figure 3) et un cadre circulaire, 50, dont la rigidité est renforcée par une croix formée de deux barres perpendiculaires B1, B2 ; les barres sont disposée s selon deux diamètres du cadre circulaire 50 et les haubans sont accrochés à l'une de leurs extrémités sous l'hélicoptère et à leur autre extrémité respectivement en des points régulièrement répartis sur le cadre 50.

Le simulateur selon la figure 3 peut également être accroché sous un ballon captif ou sous un ballon dirigeable protégé contre les champs électromagnétiques intenses.

La présente invention n'est pas limitée aux exemples décrits ; en particulier le nombre et la longueur des éléments rayonnants de l'antenne, l'angle au sommet du cône 1, le nombre et la longueur des conducteurs du contrepoids 2, le dispositif d'écartement (coupole 4 de la figure 1, élément porteur 5 de la figure 3) qui sert à maintenir, au moins lors du fonctionnement du simulateur, la forme du cône, le type de circuits utilisés, peuvent être modifiés par rapport aux exemples décrits sans sortir du cadre de l'invention. C'est ainsi que le circuit manomètrique 32 de la figure 2 peut être remplacé par une radiocommande du déclenchement du générateur de Marx. C'est ainsi également que le générateur d'impulsion, dans la mesure où il ne doit servir qu'une seule fois au cours d'un essai, peut être chargé à terre et que le simulateur peut donc ne pas comporter une alimentation qui lui soit propre et qui soit aéroportée avec lui.

D'une façon très générale l'invention s'applique à tout simulateur d'agression par impulsion électromagnétique qui utilise une antenne de type conique avec un contrepoids et qui est prévu pour être aéroporté et pour fonctionner alors qu'il est aéroporté et ceci quelle que soit les moyens mis en oeuvre pour transporter le simulateur par voie aérienne.

**Revendications**

1. Simulateur d'agression par impulsion électromagnétique, comportant une antenne à éléments rayonnants disposés sensiblement pour former un cône (1) à pointe tournée vers le bas, un générateur d'impulsions (30) couplé à l'antenne et un déclencheur (32) pour déclencher un signal de sortie du générateur, caractérisé en ce qu'il est conçu pour être aéroporté et pour fonctionner alors qu'il est aéroporté et en ce qu'il comporte pour cela un dispositif d'écartement (4 ; 5) pour maintenir la forme du cône, au moins lors du fonctionnement du simulateur, et en ce que l'antenne comporte un contrepoids radioélectrique (2) couplé électriquement aux éléments rayonnants par le générateur et disposé verticalement au-dessous de la pointe du cône, du moins lors du fonctionnement du simulateur.

2. Simulateur selon la revendication 1, destiné à être parachuté et à être utilisé lors de son parachutage, caractérisé en ce que le dispositif d'écartement est une coupole (4) de parachute et en ce que les éléments rayonnants (10) du cône (1) partent du point chaud (H) de l'antenne et sont dirigés vers la périphérie de la coupole (4).

3. Simulateur selon la revendication 1, destiné à être transporté, par voie aérienne, accroché à un engin volant (4), caractérisé en ce que le dispositif d'écartement (5) comporte un cadre circulaire (50) accroché par des haubans (H1 à H4) sous l'engin volant et en ce que les éléments rayonnants (10) du cône (1) partent du point chaud (H) de l'antenne et sont dirigés vers le cadre circulaire.

4. Simulateur selon la revendication 2, caractérisé en ce que le déclencheur (32) est un déclencheur à capsule manomètrique.

## Claims

1. A simulator of attack by electromagnetic pulse, comprising an antenna with radiating elements disposed substantially so as to form a cone (1) pointing downwards, a pulse generator (30) coupled to the antenna and a trigger device (32) for triggering an output signal from the generator, characterised in that it is designed so as to be air-lifted and to operate while it is being air-lifted and in that, for this purpose, it comprises a spacing device (4, 5) to maintain the shape of the cone, at least while the simulator is operating, and in that the antenna comprises a radio counterpoise (2) coupled electrically to the radiating elements by the generator and disposed vertically below the tip of the cone, at least while the simulator is operating.

2. A simulator according to Claim 1, intended to be parachuted and to be used while being parachuted, characterised in that the spacing device is a parachute canopy (4) and in that the radiating elements (10) of the cone (1) start from the live part (H) of the antenna and are pointed towards the periphery of the canopy (4).

3. A simulator according to Claim 1, intended to be transported by air, attached to a flying engine (4), characterised in that the spacing device (5) comprises a circular frame (50) attached by guys (H1 to H4) under the flying engine and in that the radiating elements (10) of the cone (1) start from the live part (H) of the antenna and are pointed towards the circular frame.

4. A simulator according to Claim 2, characterised in that the triggering device (32) is a triggering device having a manometric capsule.

## Patentansprüche

1. Simulator von Angriffen mit Hilfe elektromagnetischer Wellen, mit einer Antenne aus strahlenden Elementen, die im wesentlichen in Konusform (1) mit der Spitze nach unten angeordnet sind, mit einem Impulsgenerator (30), der an die Antenne gekoppelt ist und mit einem Auslöser (32), um ein Ausgangssignal des Generators auszulösen, dadurch gekennzeichnet, daß er lufttransporttauglich ist und in der Luft betrieben werden kann und daß er hierzu eine Spreizvorrichtung (4; 5) besitzt, um die Konusform zumindest während des Betriebs des Simulators aufrechtzuerhalten, und daß die Antenne ein funkelektrisches Gegengewicht (2) enthält, das elektrisch an die strahlenden Elemente über den Generator angeschlossen ist und senkrecht unter der Konusspitze zumindest während des Betriebs des Simulators angeordnet ist.

2. Simulator nach Anspruch 1, der an einem Fallschirm niedergehen soll und während des Abstiegs des Fallschirms verwendbar sein soll, dadurch gekennzeichnet, daß die Spreizvorrichtung eine Kappe (4) des Fallschirms ist und daß die strahlenden Elemente (10) des Konus vom heißen Punkt (H) der Antenne ausgehen und zum Rand der Kappe (4) führen.

3. Simulator nach Anspruch 1, der dazu bestimmt ist, an einem Luftfahrzeug (4) hängend durch die Luft transportiert zu werden, dadurch gekennzeichnet, daß die Spreizvorrichtung (5) einen ringförmigen Rahmen (50) besitzt, der mittels Tragseilen (H1 bis H4) unter dem Luftfahrzeug angehängt ist, und daß die strahlenden Elemente (10) des Konus (1) von dem heißen Punkt (H) der Antenne ausgehen und zu dem ringförmigen Rahmen führen.

4. Simulator nach Anspruch 2, dadurch gekennzeichnet, daß der Auslöser (32) eine Manometerkapsel enthält.

# FIG_1

# FIG_3

H1  H2  5  50  H4  H3  B2  B1  33  10  1  4  3  2

# FIG_2

10  1  30  GENERATEUR DE MARX  ALIMENTATION  H  F  CIRCUIT MANOME-TRIQUE  32  31  2